# EUROPÄISCHE PATENTSCHRIFT

(11) **EP 1 393 383 B1**
(45) Veröffentlichungstag und Bekanntmachung des Hinweises auf die Patenterteilung: **06.07.2005**
(21) Anmeldenummer: 02754610.0
(22) Anmeldetag: 31.05.2002
(51) Int. Cl.: H01L 29/868, H01L 21/329

(54) **LATERALE PIN-DIODE UND VERFAHREN ZUR HERSTELLUNG DERSELBEN**
LATERAL PIN DIODE AND METHOD FOR PRODUCING THE SAME
DIODE PIN LATERALE ET SON PROCEDE DE PRODUCTION

(30) Priorität: 08.06.2001 DE 10127952
(43) Veröffentlichungstag der Anmeldung: 03.03.2004
(73) Patentinhaber: Infineon Technologies AG, 81669 München (DE)
(72) Erfinder: PEICHL, Raimund, 85635 Hoehenkirchen-Siegertsbrunn (DE); SENG, Philipp, 81539 Muenchen (DE)
(74) Vertreter: Zinkler, Franz, Dipl.-Ing.
(86) Internationale Anmeldenummer: PCT/EP2002/006018
(87) Internationale Veröffentlichungsnummer: WO 2002/101837

(56) Entgegenhaltungen:
- WO-A-99/59208
- FR-A- 2 632 776
- US-A- 4 571 559
- US-A- 5 767 548
- PATENT ABSTRACTS OF JAPAN vol. 006, no. 226 (E-141), 11. November 1982 (1982-11-11) -& JP 57 128983 A (NIPPON DENKI KK), 10. August 1982 (1982-08-10)
- SRIDHAR S ET AL: "Dielectrically isolated lateral high voltage P-i-N rectifiers for power ICs" ELECTRON DEVICES MEETING, 1992. TECHNICAL DIGEST., INTERNATIONAL SAN FRANCISCO, CA, USA 13-16 DEC. 1992, NEW YORK, NY, USA,IEEE, US, 13. Dezember 1992 (1992-12-13), Seiten 245-248, XP010106551 ISBN: 0-7803-0817-4
- PATENT ABSTRACTS OF JAPAN vol. 007, no. 247 (E-208), 2. November 1983 (1983-11-02) -& JP 58 134479 A (MITSUBISHI DENKI KK), 10. August 1983 (1983-08-10)

## Beschreibung

Die vorliegende Erfindung bezieht sich auf eine PIN-Diode und ein Verfahren zu ihrer Herstellung und insbesondere auf eine PIN-Diode mit einer lateralen Stromflussrichtung.

PIN-Dioden sind Halbleiterdioden, die zwischen einem p-dotierten p-Bereich und einem n-dotierten n-Bereich einen Zwischenbereich aufweisen, der sehr viel niedriger als der p-Bereich und der n-Bereich dotiert ist und auch als intrinsischer Bereich oder i-Bereich bezeichnet wird. PIN-Dioden finden in großer Zahl unter anderem in Hochfrequenzschaltungen Anwendung, wo sie in verschiedenen Funktionen, unter anderem als passive Hochfrequenzdioden bei Frequenzen bis 50 GHz und darüber, verwendet werden. Für viele Anwendungen ist eine PIN-Diode mit einem "langen" i-Bereich wünschenswert oder erforderlich.

PIN-Dioden werden herkömmlich vertikal aufgebaut, d. h. auf ein Substrat bzw. einen Wafer werden nacheinander eine p-dotierte Halbleiterschicht als p-Bereich, eine schwach dotierte Halbleiterschicht als i-Bereich und eine n-dotierte Halbleiterschicht als n-Bereich in dieser oder der entgegengesetzten Reihenfolge aufgewachsen. Die sogenannte Länge des i-Bereichs entspricht der Dicke der schwach dotierten Halbleiterschicht. Obwohl so an sich ein beliebig langer i-Bereich hergestellt werden kann, indem eine entsprechend dicke schwach dotierte Halbleiterschicht gewachsen wird, ergeben sich in der Praxis technische Probleme. Einerseits ist es häufig erwünscht, dass die Kontakte bzw. Anschlussflächen sowohl für die Anode als auch für die Kathode auf ein und der selben Seite des Bauelements angeordnet sind, beispielsweise an der Oberfläche der auf das Substrat aufgewachsenen Schichtstruktur. Dies bedeutet, dass von der Unterseite der Schichtstruktur aus über die gesamte Bauteilhöhe eine elektrische Verbindung zu der Oberseite der Schichtstruktur hergestellt werden muss. Dies kann insbesondere bei einem langen i-Bereich (> 30 µm) bzw. einer entsprechend dicken schwach dotierten Halbleiterschicht nur sehr aufwendig gelöst werden. Andererseits entstehen bei langen i-Bereichen auch Probleme bei der Vereinzelung von auf einem Substrat hergestellten Dioden bzw. bei der Isolation der PIN-Diode von lateral benachbarten Halbleiterstrukturen an dem gleichen Substrat. Eine Vereinzelung durch Sägen des Substrats mit der aufgewachsenen Schichtstruktur der PIN-Diode erzeugt rauhe Oberflächen bzw. Sägeränder, welche sich auf die Randrekombinationseigenschaften der PIN-Diode negativ auswirken. Eine bezüglich der Randrekombinationseigenschaften wesentlich vorteilhaftere laterale Trennung bzw. Isolation einer PIN-Diode von benachbarten Bauelementen durch Ätzen eines Grabens ("Trench") ist heute technologisch auf eine Tiefe des Grabens bzw. eine Dikke der Halbleiterschichtstruktur von ca. 30 µm begrenzt. Die Herstellung von PIN-Dioden mit besonders langen i-Bereichen (> 30 µm) ist somit aufwendig und teuer in der Herstellung und erfordert Kompromisse bei den Randrekombinationseigenschaften.

Die US-A-4,571,559 beschreibt eine Begrenzungsschaltung gegen hohe Leistungen für Anwendungen im Millimeterwellenbereich, die mehrere PIN Dioden aufweist. Ein Wellenleiter ist einem Siliziumsubstart zugeordnet und in dem Wellenleiter ist eine Matrix von PIN Dioden angeordnet. Die Matrix von PIN Dioden wird dem Siliziumsubstrat gebildet, das eine Mehrzahl von Siliziumvorsprüngen aufweist, auf denen jeweils gegenüberliegend die p- und n-Bereiche angeordnet sind.

Die WO 99/59208 A1 und die US-A-5,767,548 zeigen Bauelemente mit lateralen Diodenstrukturen, bei denen die Diodenstruktur auf einem Wafer erzeugt wird. Die Kontaktierung der Diodenstruktur erfolgt über herkömmliche Kontaktstellen, die auf der Oberfläche der sich ergebenden Gesamtstruktur angeordnet sind.

Die Aufgabe der vorliegenden Erfindung besteht darin, eine verbesserte PIN-Diode zu schaffen, die einen langen i-Bereich aufweist, einfach herzustellen ist und eine gute Kontaktierung ermöglicht.

Diese Aufgabe wird durch ein Verfahren gemäß Anspruch 1 oder eine PIN-Diode gemäß Anspruch 8 gelöst.

Der vorliegenden Erfindung liegt die Idee zugrunde, eine PIN-Diode horizontal, d. h. parallel zu einer Waferoberfläche, anzuordnen, um unabhängig von der Dicke einer schwach dotierten Halbleiterschicht, die zur Bildung des i-Bereichs dient, einen langen i-Bereich zu erzielen. Eine Kombination der "Trench"-Technologie ("Graben"-Technologie) und der Technologie des Waferbondens ermöglicht die Herstellung von PIN-Dioden mit einer horizontalen P-I-N-Struktur. Die Trench-Technologie schafft qualitativ hochwertige passivierende Oxidgrenzflächen, welche eine geringe Rekombinationsrate hervorrufen. Die horizontale Anordnung der P-I-N-Struktur ermöglicht zusätzliche Freiheitsgrade in der Wahl der Orientierung und der Querschnitte des Strom/Signalflusses. Besonders PIN-Dioden mit langen i-Bereichen, die bisher nur vertikal mittels einer besonders dicken Epitaxie (30 µm bis 150 µm) realisiert werden konnten, sind nun einfacher und mit verschiedenen Parametern realisierbar. Insbesondere ist es nun einfach möglich, die Anschlussflächen für Anode und Kathode an der gleichen Waferoberfläche bzw. an der gleichen Seite des Bauelements auszuführen. Dadurch wird beispielsweise die Gestaltung der PIN-Diode als "Flip-Chip" möglich. Die Verwendung der Technologie des direkten Waferbondens ermöglicht ferner eine vollständig in Oxid gekapselte PIN-Diode.

Als Ausgangsmaterial für eine PIN-Diode gemäß der vorliegenden Erfindung kann ein "Direct-Bonded"-Wafer verwendet werden, der bereits eine isolierende Oxidschicht zwischen dem Handhabungs- bzw. Trägerwafer, der im folgenden meist nur Substrat genannt wird, und dem Bauelement- bzw. Device-Wafer, der im folgenden Bauelementsubstrat genannt wird, aufweist. Diese isolierende Oxidschicht bildet eine Grenzfläche des späteren i-Bereichs der PIN-Diode. Parallel zur Richtung des späteren Stromflusses werden "Trenches" bzw. Gräben in das Bauelementsubstrat geätzt, die von der offenliegenden Oberfläche des Bauelementsubstrats bis zu der isolierenden Oxidschicht zwischen dem Bauelementsubstrat und dem Substrat reichen. Desgleichen werden Gräben senkrecht zur Stromrichtung geätzt. Damit ist der Bereich der späteren PIN-Diode durch Oxidschichten lateral vom restlichen Bauelementsubstrat isoliert. Durch die im wesentlichen nur durch die laterale Ausdehnung des Bauelementsubstrats beschränkte laterale Gestalt und Ausdehnung der Gräben entsteht eine große Freiheit in der Gestaltung der Form und der Querschnitte der PIN-Diode und ihrer einzelnen p-, n- und i-Bereiche. So ist es insbesondere einfach möglich, einen sehr langen i-Bereich, der im folgenden meist als Zwischenbereich bezeichnet wird, zu schaffen. Die Länge des i-Bereichs bzw. Zwischenbereichs ist dabei insbesondere von der Tiefe der Gräben unabhängig.

Zur Herstellung des p-Bereichs und des n-Bereichs der lateralen PIN-Diode können ebenfalls geätzte Gräben verwendet werden, die mit hoch leitfähigem p+- bzw. n+-Polysilizium gefüllt werden. Alternativ kann eine geeignete Dotierung des Halbleiters zur Herstellung des p-Bereichs und des n-Bereichs durch eine steile Implantation des entsprechenden p-Materials bzw. n-Materials in die für den p-Bereich bzw. den n-Bereich vorbestimmten Bereiche des Bauelementsubstrats erfolgen. Eine weitere Alternative ist das Ätzen von Gräben, die anschließend mit Phosphor bzw. Bor als Dotiermaterial belegt werden, wobei die Dotiermaterialien anschließend in die die Gräben umgebenden Bereiche des Bauelementsubstrats eindiffundiert werden. Wird die isolierende Oxidschicht zwischen dem Bauelementsubstrat und dem Substrat unter dem p-Bereich oder dem n-Bereich aufgeätzt, kann ein Kontakt mit dem Substrat hergestellt werden, wodurch auch eine Kontaktierung des p-Bereichs oder n-Bereichs über die Rückseite des Substrats möglich wird. In oder hinter dem p-Bereich oder dem n-Bereich kann eine von der Oberfläche des Bauelementsubstrats in die Tiefe reichende Schicht mit erhöhter Leitfähigkeit, z. B. aus Metall-Silizid oder Wolfram, vorgesehen sein. Dadurch wird ein Spannungsabfall innerhalb des p-Bereichs bzw. des n-Bereichs bei Stromfluss durch die PIN-Diode verringert und eine homogenere Stromverteilung innerhalb der PIN-Diode ermöglicht. Schließlich wird die Struktur durch eine Oxid/Nitrid-Sandwich-Passivierung abgedeckt. Durch eine geeignete Wahl der Geometrie der Diodenbereiche können verschiedene elektrische Parameter optimiert werden. Zum Beispiel kann mit einer konzentrischen oder einer Tortenschnitt-Geometrie (kleiner n-Bereich und großer p-Bereich) eine PIN-Diode mit besonders guten IP3-Eigenschaften und einem besonders guten Flusswiderstand Rf realisiert werden.

Gemäß einem bevorzugten Ausführungsbeispiel der vorliegenden Erfindung umfasst ein Verfahren zur Herstellung einer PIN-Diode einen Schritt des Bildens eines p-Bereichs auf einer ersten, mit einer isolierenden Schicht vorgesehenen Oberfläche eines Substrats, einen Schritt des Bildens eines n-Bereichs auf der ersten Oberfläche des Substrats beabstandet von dem p-Bereich, einen Schritt des Bildens eines Zwischenbereichs auf der ersten Oberfläche des Substrats zwischen dem n-Bereich und dem p-Bereich, wobei eine Dotierungskonzentration des Zwischenbereichs niedriger ist als eine Dotierungskonzentration des p-Bereichs und niedriger ist als eine Dotierungskonzentration des n-Bereichs, einen Schritt des Bildens eines ersten elektrisch leitfähigen Baugliedes an einer von dem Zwischenbereich abgewandten Seite des p-Bereichs und einen Schritt des Bildens eines zweiten elektrisch leitfähigen Baugliedes an einer von dem Zwischenbereich abgewandten Seite des n-Bereichs. Vorzugsweise umfasst das Verfahren ferner einen Schritt des Bereitstellens des Substrats und eines Bauelementsubstrats und einen Schritt des Waferbondens von Substrat und Bauelementsubstrat, wobei der p-Bereich, der n-Bereich und der Zwischenbereich in dem Bauelementsubstrat gebildet werden und von dem Substrat isoliert sind. Ferner vorzugsweise wird in einem an den Zwischenbereich angrenzenden Abschnitt des Bauelementsubstrats ein Graben gebildet, der sich ausgehend von einer Oberfläche des Bauelementsubstrats, die dem Substrat abgewandt ist, bis zu einer Oberfläche des Bauelementsubstrats, die dem Substrat gegenüber liegt, erstreckt, und der ferner in an den p-Bereich und an den n-Bereich angrenzenden Abschnitten des Bauelementsubstrats angeordnet sein kann. Der Graben kann mit einem isolierenden Material gefüllt werden und grenzt ferner vorzugsweise unmittelbar an den Zwischenbereich bzw. den p-Bereich und den n-Bereich an. Das Verfahren kann ferner einen Schritt des Bildens einer isolierenden Schicht über dem p-Bereich, dem n-Bereich und dem Zwischenbereich umfassen, so dass bei entsprechender Gestaltung des Grabens eine vollständig in Oxid gekapselte, laterale PIN-Diode entsteht.

Gemäß einem weiteren bevorzugten Ausführungsbeispiel der vorliegenden Erfindung umfasst eine PIN-Diode einen p-Bereich auf einer ersten, mit einer isolierenden Schicht vorgesehenen Oberfläche eines Substrats, einen n-Bereich auf der ersten Oberfläche des Substrats und einen Zwischenbereich auf der ersten Oberfläche des Substrats zwischen dem n-Bereich und dem p-Bereich, wobei eine Dotierungskonzentration des Zwischenbereichs niedriger ist als eine Dotierungskonzentration des p-Bereichs und niedriger ist als eine Dotierungskonzentration des n-Bereichs. Die PIN-Diode umfaßt ferner ein erstes elektrisch leitfähiges Bauglied, das an einer von dem Zwischenbereich abgewandten Seite des p-Bereichs angeordnet ist, und ein zweites elektrisch leitfähiges Bauglied, das an einer von dem Zwischenbereich abgewandten Seite des n-Bereichs angeordnet ist. Das Substrat weist an seiner ersten Oberfläche eine isolierende Schicht auf, auf der ein Bauelementsubstrat angeordnet ist, wobei der p-Bereich, der n-Bereich und der Zwischenbereich in dem Bauelementsubstrat angeordnet sind. Ein Graben in einem an den Zwischenbereich angrenzenden Abschnitt des Bauelementsubstrats, der sich ausgehend von einer Oberfläche des Bauelementsubstrats, die dem Substrat abgewandt ist, bis zu einer Oberfläche des Bauelementsubstrats, die dem Substrat gegenüber liegt, erstreckt, und der mit einem isolierenden Material gefüllt sein kann, kann den Zwischenbereich, und, wenn er ferner in an den p-Bereich und den n-Bereich angrenzenden Abschnitten des Bauelementsubstrats angeordnet ist, den p-Bereich und den n-Bereich gegenüber anderen Bereichen des Bauelementsubstrats isolieren. Die PIN-Diode kann ferner eine Isolierschicht aufweisen, welche die von dem Substrat abgewandten Oberflächen des n-Bereichs, des p-Bereichs und des Zwischenbereichs bedeckt. Der Zwischenbereich kann lateral die Form eines Rechtecks, eines Trapezes, eines Kreises oder eine andere Form aufweisen, wobei der p-Bereich und der n-Bereich an zwei gegenüberliegenden Seiten des Rechtecks oder des Trapezes angeordnet sein können. Sowohl der p-Bereich als auch der n-Bereich kann sich jeweils über eine gesamte Seite oder über einen Teil einer Seite erstrecken. Ferner kann die laterale Form des Zwischenbereichs kreisförmig sein, wobei der p-Bereich oder der n-Bereich sich kreisförmig entlang des Randes des Zwischenbereichs erstrecken kann, der n-Bereich bzw. der p-Bereich im wesentlichen in der Mitte des Zwischenbereichs angeordnet ist und in seiner Mitte das zweite elektrisch leitfähige Bauglied bzw. das erste elektrisch leitfähige Bauglied angeordnet ist.

Ein Vorteil der erfindungsgemäßen PIN-Diode bzw. des erfindungsgemäßen Verfahrens zur Herstellung einer PIN-Diode ist die Möglichkeit eines langen Zwischenbereichs bzw. eines langen i-Bereichs. Durch die laterale Anordnung von p-Bereich, i-Bereich bzw. Zwischenbereich und n-Bereich ist die Länge des i-Bereichs in Stromrichtung von der Dicke der schwach dotierten Halbleiterschicht, welche den Zwischenbereich bildet, unabhängig und kann auf einfache Weise nahezu beliebig verlängert werden. Ein weiterer Aspekt ist die dadurch verminderte Einbauhöhe der erfindungsgemäßen PIN-Diode, die nun in keinem Zusammenhang mehr mit der Länge des Zwischenbereichs steht. Da bei der erfindungsgemäßen PIN-Diode der Zwischenbereich unabhängig von seiner Länge in Stromrichtung seitlich vollständig von Oxidschichten umgeben ist, sind die Ladungsträgerrekombinationseigenschaften der erfindungsgemäßen PIN-Diode beispielsweise gegenüber herkömmlichen PIN-Dioden mit langem i-Bereich, die durch Sägeflächen vereinzelt werden, welche an den i-Bereich direkt angrenzen, deutlich verbessert. Weiterhin ermöglicht die erfindungsgemäße PIN-Diode eine völlig unaufwendige Anordnung beider Anschlüsse (für den p-Bereich und den n-Bereich) an der gleichen Seite bzw. Oberfläche der PIN-Diode. Die erfindungsgemäße PIN-Diode ist deshalb in besonderem Maße für den Einsatz innerhalb der Flip-Chip-Technologie geeignet.

Bevorzugte Ausführungsbeispiele der vorliegenden Erfindung werden nachfolgend bezugnehmend auf die beiliegenden Zeichnungen näher erläutert. Es zeigen:
- Fig. 1a: eine schematische Darstellung einer PIN-Diode gemäß einem ersten Ausführungsbeispiel der vorliegenden Erfindung;
- Fig. 1b: eine schematische Draufsicht-Darstellung der PIN-Diode aus Fig. 1a;
- Fig. 2: eine schematische Draufsicht-Darstellung einer PIN-Diode gemäß einem weiteren Ausführungsbeispiel der vorliegenden Erfindung;
- Fig. 3: eine schematische Draufsicht-Darstellung einer PIN-Diode gemäß der vorliegenden Erfindung;
- Fig. 4a: eine schematische Darstellung einer PIN-Diode gemäß einem weiteren Ausführungsbeispiel der vorliegenden Erfindung im vertikalen Querschnitt;
- Fig. 4b: eine schematische Draufsicht-Darstellung der PIN-Diode aus Fig. 4a;
- Fig. 5a: eine schematische Darstellung einer PIN-Diode gemäß einem weiteren Ausführungsbeispiel der vorliegenden Erfindung im vertikalen Querschnitt;
- Fig. 5b: eine schematische Draufsicht-Darstellung der PIN-Diode aus Fig. 5a;
- Fig. 6a: eine schematische Darstellung einer PIN-Diode gemäß einem weiteren Ausführungsbeispiel der vorliegenden Erfindung im vertikalen Querschnitt;
- Fig. 6b: eine schematische Draufsicht-Darstellung der PIN-Diode aus Fig. 6a;
- Fig. 7a: eine schematische Darstellung einer PIN-Diode gemäß einem weiteren Ausführungsbeispiel der vorliegenden Erfindung im vertikalen Querschnitt;
- Fig. 7b: eine schematische Draufsicht-Darstellung der PIN-Diode aus Fig. 7a;
- Fig. 8a: eine schematische Darstellung einer PIN-Diode gemäß einem weiteren Ausführungsbeispiel der vorliegenden Erfindung im vertikalen Querschnitt;
- Fig. 8b: eine schematische Draufsicht-Darstellung der PIN-Diode aus Fig. 8a;
- Fig. 9a: eine schematische Darstellung einer PIN-Diode gemäß einem weiteren Ausführungsbeispiel der vorliegenden Erfindung im vertikalen Querschnitt; und
- Fig. 9b: eine schematische Draufsicht-Darstellung der PIN-Diode aus Fig. 9a.

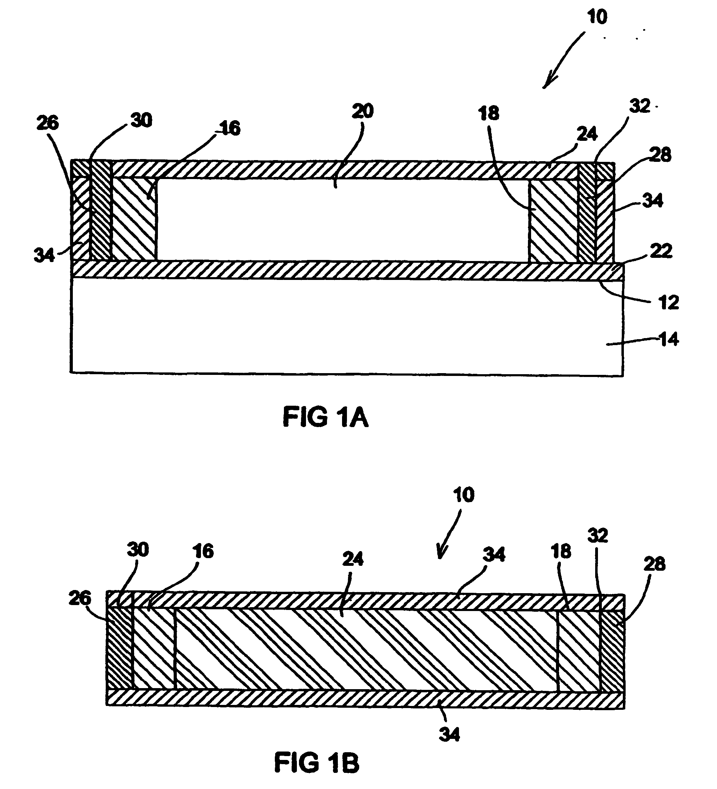

Fig. 1a zeigt eine schematische Darstellung einer PIN-Diode 10 gemäß einem ersten bevorzugten Ausführungsbeispiel der vorliegenden Erfindung in einer vertikalen Schnittansicht, d. h. in einer Ansicht eines Schnittes entlang einer Ebene senkrecht zu einer ersten Oberfläche 12 eines Substrats 14, auf der die PIN-Diode 10 gebildet ist. Fig. 1b zeigt eine schematische Darstellung der gleichen PIN-Diode 10 in einer horizontalen Schnittansicht, d. h. in einem Querschnitt entlang einer Ebene parallel zu der ersten Oberfläche 12 des Substrats 14. Die PIN-Diode 10 weist einen p-Bereich 16, einen n-Bereich 18 und einen Zwischenbereich bzw. i-Bereich 20 auf. Zwischen dem Substrat 14 einerseits und dem p-Bereich 16, dem n-Bereich 18 und dem Zwischenbereich 20 andererseits ist an der ersten Oberfläche 12 des Substrats 14 eine erste isolierende Oxidschicht 22 angeordnet. Desgleichen ist an den von der ersten Oberfläche 12 des Substrats 14 abgewandten Oberfläche des p-Bereichs 16, des n-Bereichs 18 und des Zwischenbereichs 20 eine zweite isolierende Oxidschicht angeordnet, die im wesentlichen zu der ersten isolierenden Oxidschicht 22 parallel ist. Der Zwischenbereich 20 weist in lateraler Richtung (Fig. 1b) im wesentlichen die Form eines Rechtecks auf. Der p-Bereich 16 und der n-Bereich 18 sind an gegenüberliegenden Seiten dieses Rechtecks angeordnet und grenzen über die gesamte Breite der jeweiligen Seite an den Zwischenbereich direkt an. In vertikaler Richtung, d. h. in Richtung senkrecht zu der ersten Oberfläche 12 des Substrats 14, erstrecken sie sich genau wie der Zwischenbereich 20 von der ersten isolierenden Oxidschicht 22 bis zu der zweiten isolierenden Oxidschicht 24 und grenzen über diese gesamte Höhe direkt an den Zwischenbereich 20 an. An der von dem Zwischenbereich 20 abgewandten Seite des p-Bereichs 16 ist ein erstes elektrisch leitfähiges Bauglied 26 angeordnet, das über die gesamte Fläche der von dem Zwischenbereich 20 abgewandten Seite des p-Bereichs 16 an diesen direkt angrenzt, wodurch ein großflächiger elektrischer Kontakt zwischen dem p-Bereich 16 und dem ersten elektrisch leitfähigen Bauglied 26 hergestellt ist. Desgleichen ist an der von dem Zwischenbereich 20 abgewandten Seite des n-Bereichs 18 ist ein zweites elektrisch leitfähiges Bauglied 28 angeordnet, welches wiederum über die gesamte Fläche der von dem Zwischenbereich 20 abgewandten Seite des n-Bereichs 18 an diesen direkt angrenzt, wodurch ein großflächiger elektrischer Kontakt zwischen dem n-Bereich 18 und dem zweiten elektrisch leitfähigen Bauglied 28 hergestellt ist. Die elektrisch leitfähigen Bauglieder 26, 28 reichen in vertikaler Richtung von der ersten isolierenden Oxidschicht 22 bis zu der von dem Substrat 14 abgewandten Oberfläche der zweiten isolierenden Oxidschicht 24, wo sie lateral erweitert sind, um elektrische Kontakte bzw. Anschlussflächen 30, 32 zu bilden. Lateral an den p-Bereich 16, den n-Bereich 18, den Zwischenbereich 20, das erste elektrisch leitfähige Bauglied 26 und das zweite elektrisch leitfähige Bauglied 28 angrenzend ist ein umlaufender Graben bzw. "Trench" 34 angeordnet, der sich in vertikaler Richtung von der zweiten isolierenden Oxidschicht 24 bis zu der ersten isolierenden Oxidschicht 22 erstreckt. Der Graben 34 ist mit isolierendem Material gefüllt und umschließt in lateraler Richtung den p-Bereich 16, den n-Bereich 18, den Zwischenbereich 20 und die beiden elektrisch leitfähigen Bauglieder 26, 28 vollständig, so dass er diese gegebenenfalls von anderen, lateral benachbarten Halbleiterstrukturen oder Bauelementen auf der ersten Oberfläche 12 des Substrats 14 elektrisch isoliert. Die erste isolierende Oxidschicht 22, die zweite isolierende Oxidschicht 24 und der mit einem isolierenden Material gefüllte Graben 34 bilden zusammen eine vollständige Kapselung des p-Bereichs 16, des n-Bereichs 18, des Zwischenbereichs 20, des ersten elektrisch leitfähigen Bauglieds 26 und des zweiten elektrisch leitfähigen Bauglieds 28, welche gemeinsam die PIN-Diode 10 bilden.

Der Zwischenbereich 20 besteht aus einem niedrig dotierten Halbleitermaterial und bildet den "intrinsischen" Bereich bzw. i-Bereich der PIN-Diode 10. Der Zwischenbereich 20 weist eine Dotierungskonzentration auf, die niedriger oder wesentlich niedriger ist als die Dotierungskonzentrationen des p-Bereichs 16 und des n-Bereichs 18. Der p-Bereich 16 besteht aus einem p-dotierten Halbleitermaterial und der n-Bereich besteht aus einem n-dotierten Halbleitermaterial. Der p-Bereich 16, der Zwischenbereich 20 und der n-Bereich 18 bilden zusammen die eigentliche P-I-N-Struktur der PIN-Diode 10. Das erste elektrisch leitfähige Bauglied 26 und das zweite elektrisch leitfähige Bauglied 28 bestehen beispielsweise aus Wolfram, Metall-Silizid oder einem anderen gut leitfähigen Material und dienen dazu, auch bei einem Stromfluss durch die PIN-Diode 10 einen Spannungsabfall innerhalb des p-Bereichs 16 bzw. des n-Bereichs 18 aufgrund der beschränkten Leitfähigkeit des p-Bereichs 16 bzw. des n-Bereichs 18 zu minimieren und so eine über den Querschnitt der PIN-Diode 10 homogene Stromverteilung zu gewährleisten. Wäre die erste Anschlussfläche 30 bzw. die zweite Anschlussfläche 32 ohne das erste elektrisch leitfähige Bauglied 26 bzw. das zweite elektrisch leitfähige Bauglied 28 mit dem p-Bereich 16 bzw. dem n-Bereich 18 leitfähig verbunden, so würde bei Stromfluss durch die PIN-Diode 10 ein Spannungsabfall von der mit der ersten Anschlussfläche 30 bzw. der zweiten Anschlussfläche 32 verbundenen Oberseite des p-Bereichs 16 bzw. n-Bereichs 18 zu der an die erste isolierende Oxidschicht 22 angrenzende Unterseite des p-Bereichs 16 bzw. des n-Bereichs 18 auftreten, was eine über den Querschnitt der PIN-Diode 10 inhomogene Stromverteilung zur Folge hätte.

Der Zwischenbereich 20 der in den Fig. 1a und 1b dargestellten PIN-Diode 10 weist eine Länge in Richtung des Stromflusses zwischen dem p-Bereich und dem n-Bereich auf, die deutlich größer ist als die Breite des Zwischenbereichs 20 parallel zu der ersten Oberfläche 12 des Substrats 14 und senkrecht zu der Stromflussrichtung, und die ferner deutlich größer ist als die Breite des Zwischenbereichs senkrecht zu der ersten Oberfläche 12 des Substrats 14 und senkrecht zu der Stromflussrichtung. Insbesondere ist die Länge des Zwischenbereichs 20 in Richtung des Stromflusses zwischen dem p-Bereich 16 und dem n-Bereich 18 von der Dicke des Zwischenbereichs 20, d. h. von der Abmessung des Zwischenbereichs 20 senkrecht zu der ersten Oberfläche 12 des Substrats 14, unabhängig. Die Länge des Zwischenbereichs 20 entspricht dem Abstand zwischen dem p-Bereich 16 und dem n-Bereich 18, deren laterale Anordnung zwischen der ersten isolierenden Oxidschicht 22 und der zweiten isolierenden Oxidschicht 24 im wesentlichen frei wählbar ist und nur durch die lateralen Abmessungen des Substrats 14 bzw. durch anwendungsspezifische Größenanforderungen an die PIN-Diode 10 beschränkt ist. Alternativ kann auf die zweite isolierende Schicht 24 auch verzichtet werden.

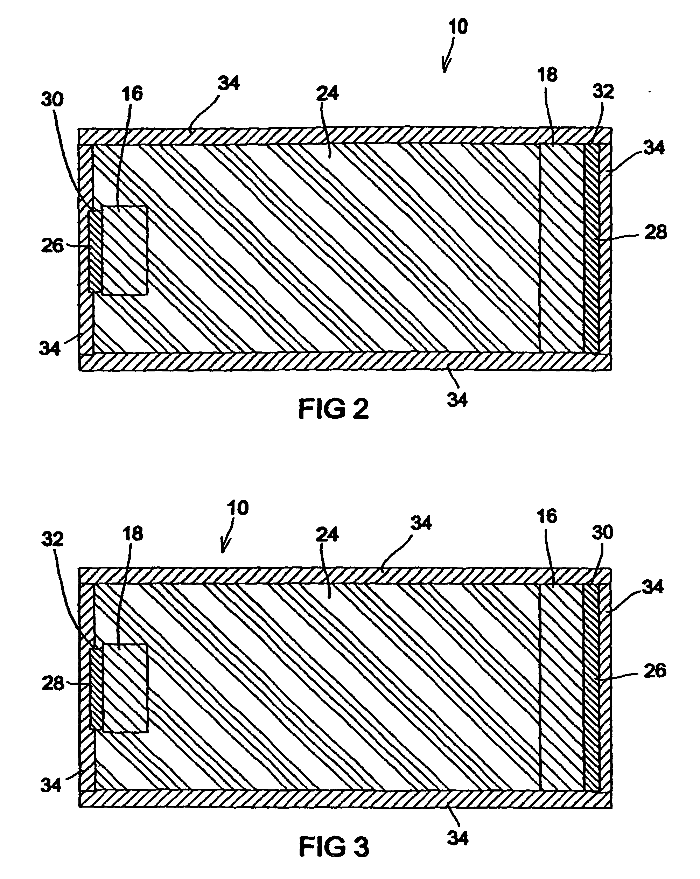

Abweichend von dem in den Fig. 1a und 1b dargestellten Ausführungsbeispiel der erfindungsgemäßen PIN-Diode 10 sind zahlreiche Varianten und Modifikationen möglich. Es ist eine wichtige Eigenschaft der vorliegenden Erfindung, dass sie völlig neue Freiheitsgrade bei der Gestaltung des Zwischenbereichs 20 ermöglicht. Die Fig. 2 bis 9b stellen weitere Ausführungsbeispiele der PIN-Diode 10 gemäß der vorliegenden Erfindung dar.

Fig. 2 zeigt eine schematische Darstellung eines Ausführungsbeispiels der PIN-Diode 10 gemäß der vorliegenden Erfindung in einem horizontalen Schnitt. Der Zwischenbereich 20 weist bei diesem Ausführungsbeispiel in lateraler Richtung erneut die Form eines Rechtecks auf, das von dem Graben 34 begrenzt wird. Im Gegensatz zu dem in Fig. 1 dargestellten Ausführungsbeispiel ist der Zwischenbereich 20 jedoch in lateraler Richtung quer zur Stromrichtung breiter. Der n-Bereich 18 erstreckt sich über die gesamte Breite einer Seite des Zwischenbereichs 20. Der an der gegenüberliegenden Seite des Zwischenbereichs 20 angeordnete p-Bereich 16 erstreckt sich im Gegensatz dazu in lateraler Richtung nur über einen Teil der Seite, wobei der p-Bereich 16 gegenüber dem durch den Graben 34 definierten Rand des Zwischenbereichs 20 in lateraler Richtung vorspringt. In allen weiteren Merkmalen entspricht das in Fig. 2 dargestellte Ausführungsbeispiel dem in den Fig. 1a und 1b dargestellten ersten Ausführungsbeispiel.

Fig. 3 zeigt eine schematische Darstellung einer PIN-Diode 10 gemäß einem weiteren Ausführungsbeispiel der vorliegenden Erfindung. Dieses Ausführungsbeispiel unterscheidet sich von dem in Fig. 2 dargestellten Ausführungsbeispiel dadurch, dass der p-Bereich 16 und der n-Bereich 18 vertauscht sind, d. h. dass nun der p-Bereich 16 in lateraler Richtung die gesamte Breite des durch den Zwischenbereich 20 gebildeten Rechtecks einnimmt und der n-Bereich 18 nur einen Teil der Breite der gegenüberliegenden Seite des Rechtecks einnimmt und gegenüber dem durch den Graben 34 definierten Rand des Zwischenbereichs an dieser Seite vorspringt. In allen weiteren Merkmalen stimmt das in Fig. 3 gezeigte Ausführungsbeispiel mit den erste beiden Ausführungsbeispielen überein.

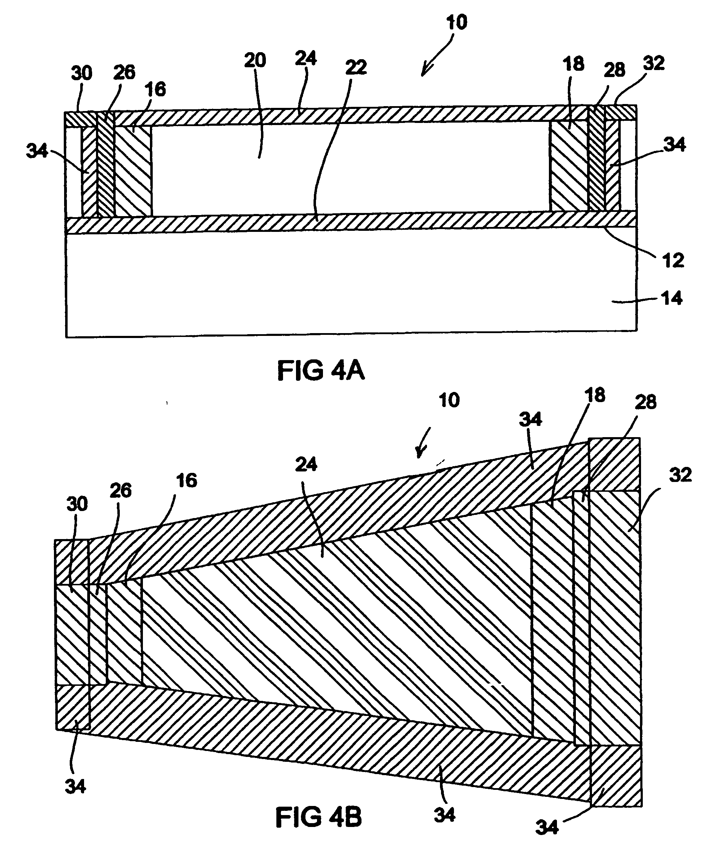

Die Fig. 4a und 4b zeigen schematische Darstellungen eines weiteren Ausführungsbeispiels einer PIN-Diode 10 gemäß der vorliegenden Erfindung. Wie es in Fig. 4b zu erkennen ist, weist der Zwischenbereich 20 in lateraler Richtung die Form eines Trapezes auf, wobei der p-Bereich 16 und der n-Bereich 18 an den beiden gegenüberliegenden parallelen Seiten des Trapezes angeordnet sind. Sowohl der p-Bereich 16 als auch der n-Bereich 18 erstrecken sich über die gesamte Breite der jeweiligen Seite. In dem in Fig. 4a gezeigten vertikalen Schnitt und in allen weiteren Merkmalen stimmt das Ausführungsbeispiel mit den vorhergehenden Ausführungsbeispielen überein.

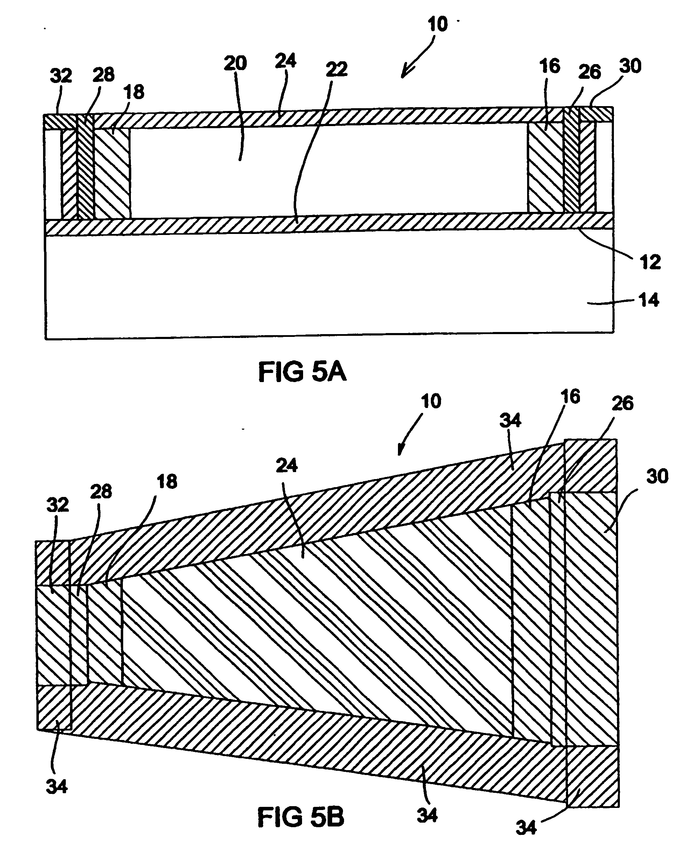

Die Fig. 5a und 5b zeigen schematisch ein weiteres Ausführungsbeispiel der PIN-Diode 10 gemäß der vorliegenden Erfindung im vertikalen Schnitt bzw. im horizontalen Schnitt. Das Ausführungsbeispiel unterscheidet sich vom vorangehenden Ausführungsbeispiel nur dadurch, dass der p-Bereich 16 und der n-Bereich 18 vertauscht sind, so dass der p-Bereich 16 an der langen parallelen Seite des Trapezes angeordnet ist und der n-Bereich 18 an der kurzen Seite des Trapezes angeordnet ist. In allen weiteren Merkmalen stimmt das Ausführungsbeispiel mit den vorangehenden, in den Fig. 4a und 4b gezeigten Ausführungsbeispiel überein.

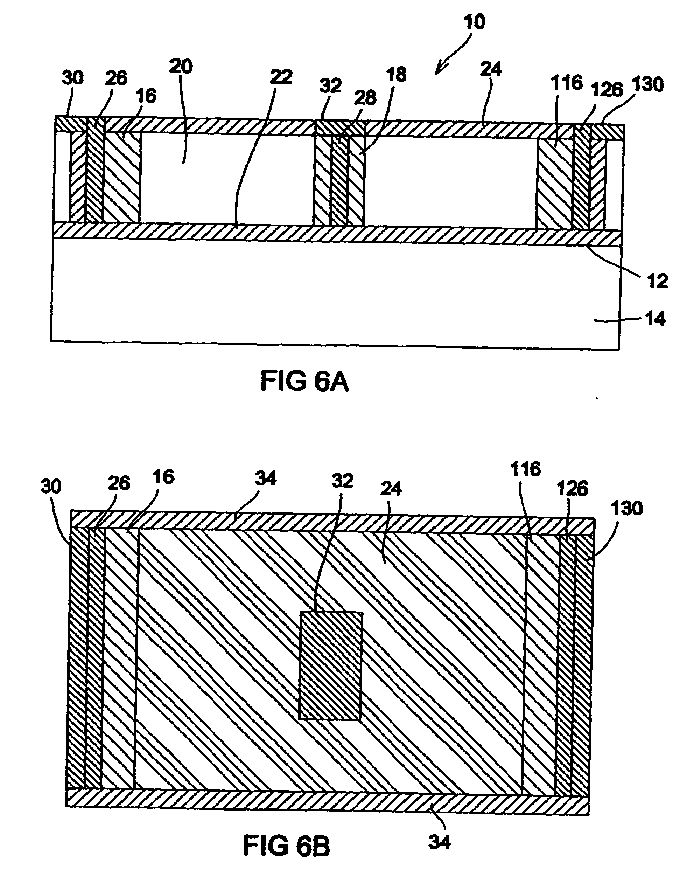

Die Fig. 6a und 6b zeigen schematisch ein weiteres Ausführungsbeispiel der PIN-Diode 10 gemäß der vorliegenden Erfindung im vertikalen Schnitt bzw. im horizontalen Schnitt. Der Zwischenbereich 20 weist in lateraler Richtung die Form eines Rechtecks auf. Der p-Bereich 16 ist an einer Seite des Rechtecks angeordnet und erstreckt sich in lateraler Richtung über ihre gesamte Breite. An der gegenüberliegenden Seite des Rechtecks ist ein weiterer p-Bereich 116 angeordnet, der sich über die gesamte Breite dieser Seite erstreckt. Wie in den vorangehenden Ausführungsbeispielen ist an der von dem Zwischenbereich 20 abgewandten Seite des p-Bereichs 16 das erste elektrisch leitfähige Bauglied 26 angeordnet, das über die gesamte Fläche der von dem Zwischenbereich 20 abgewandten Seite des p-Bereichs 16 mit diesem in Kontakt steht. An dem an der zweiten isolierenden Oxidschicht 24 angrenzenden Ende des ersten elektrisch leitfähigen Bauglieds 26 ist die erste Anschlussfläche 30 gebildet. Entsprechend ist an der von dem Zwischenbereich 20 abgewandten Seite des weiteren p-Bereichs 116 ein drittes elektrisch leitfähiges Bauglied angeordnet, das sich, wie das erste elektrisch leitfähige Bauglied 26, in lateraler Richtung über die gesamte Breite des weiteren p-Bereichs 116 und in vertikaler Richtung von der zweiten isolierenden Oxidschicht 24 bis zu der ersten isolierenden Oxidschicht 22 erstreckt und mit dem weiteren p-Bereich 116 in elektrischem Kontakt steht. An dem zu der zweiten isolierenden Oxidschicht 24 benachbarten Ende des dritten elektrisch leitfähigen Bauglieds 126 ist eine dritte Anschlussfläche 130 ausgebildet. Der n-Bereich 18 ist in lateraler Richtung im wesentlichen in der Mitte des Zwischenbereichs so angeordnet, dass er vollständig von dem Zwischenbereich 20 umgeben ist, nicht an den den Zwischenbereich 20 begrenzenden Graben 34 angrenzt und von dem p-Bereich 16 und dem weiteren p-Bereich 116 im wesentlichen gleich weit beabstandet ist. Der n-Bereich 18 weist in lateraler Richtung vorzugsweise die Form eines Rechtecks auf, wobei das zweite elektrisch leitfähige Bauglied 28 im wesentlichen in der Mitte des n-Bereichs 18 angeordnet ist. An dem zu der zweiten isolierenden Oxidschicht 24 benachbarten Ende des zweiten elektrisch leitfähigen Bauglieds 28 ist die zweite Anschlussfläche 32 ausgebildet. Die PIN-Diode 10 des vorliegenden Ausführungsbeispiels ist wie die PIN-Dioden der vorangehenden Ausführungsbeispiele zwischen einer ersten isolierenden Oxidschicht 22 und einer zweiten isolierenden Oxidschicht 24 an einer ersten Oberfläche 12 des Substrats 14 angeordnet. Der p-Bereich 16, der n-Bereich 18, der Zwischenbereich 20, der weitere p-Bereich 116, das erste elektrisch leitfähige Bauglied 26, das zweite elektrisch leitfähige Bauglied 28 und das dritte elektrisch leitfähige Bauglied 126 sind in lateraler Richtung von einem mit einem isolierenden Material gefüllten Graben 34 umgeben, der sie von lateral benachbarten Bereichen, Halbleiterstrukturen oder Bauelementen an der ersten Oberfläche 12 des Substrats 14 isoliert.

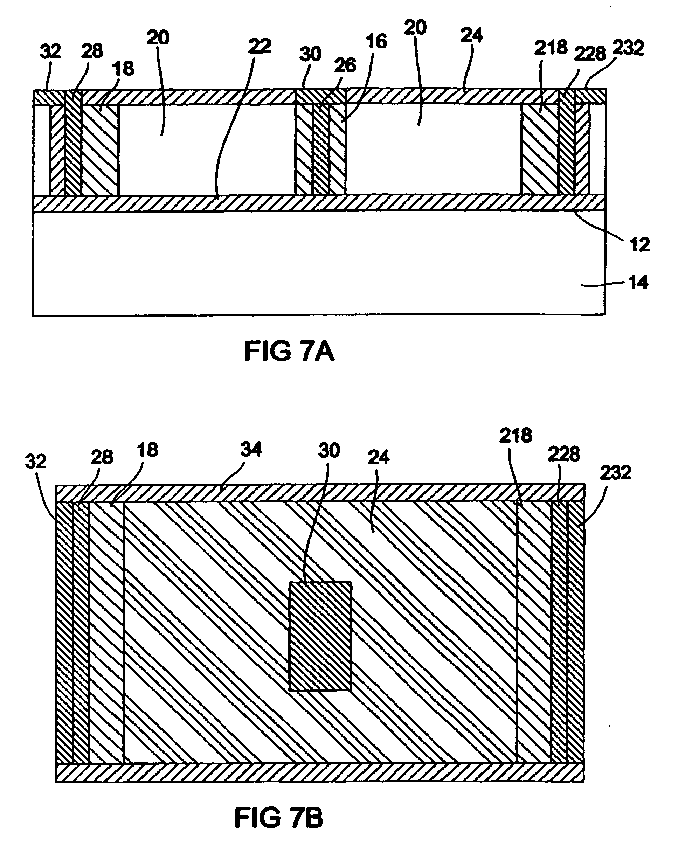

Die Fig. 7a und 7b zeigen schematisch ein weiteres Ausführungsbeispiel der PIN-Diode 10 gemäß der vorliegenden Erfindung im vertikalen Schnitt bzw. im horizontalen Schnitt. Das Ausführungsbeispiel unterscheidet sich von dem in den Fig. 6a und 6b dargestellten Ausführungsbeispiel dadurch, dass der p-Bereich 16 und der n-Bereich 18 vertauscht sind, d. h. der p-Bereich 16 ist im wesentlichen in der Mitte des Zwischenbereichs 20 angeordnet und der n-Bereich 18 ist an einer Seite des in lateraler Richtung rechteckförmigen Zwischenbereichs 20 angeordnet und erstreckt sich über die gesamte Breite dieser Seite. Ferner unterscheidet sich das Ausführungsbeispiel dadurch, dass anstelle eines weiteren p-Bereichs 116 ein weiterer n-Bereich 218 an der dem n-Bereich 18 gegenüberliegenden Seite des Zwischenbereichs 20 angeordnet ist. An der von dem Zwischenbereich 20 abgewandten Seite des weiteren n-Bereichs 218 ist ein drittes elektrisch leitfähiges Bauglied 228 angeordnet, das sich in lateraler Richtung über die gesamte Breite des weiteren n-Bereichs 218 und in vertikaler Richtung von der zweiten isolierenden Oxidschicht 24 bis zu der ersten isolierenden Oxidschicht 22 erstreckt und mit dem weiteren n-Bereich 218 in elektrischem Kontakt steht. An dem zu der zweiten isolierenden Oxidschicht 24 benachbarten Ende des dritten elektrisch leitfähigen Bauglieds 228 ist eine dritte Anschlussfläche 232 ausgebildet. In allen weiteren Merkmalen stimmt das Ausführungsbeispiel mit dem in den Fig. 6a und 6b gezeigten Ausführungsbeispiel entsprechend überein.

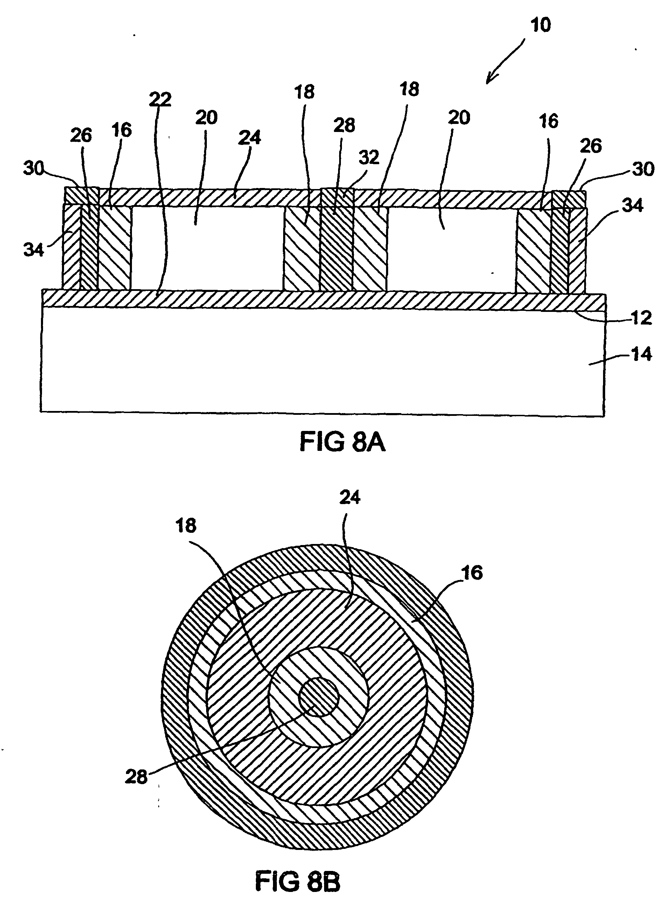

Die Fig. 8a und 8b zeigen schematisch ein weiteres Ausführungsbeispiel der erfindungsgemäßen PIN-Diode 10 im vertikalen Schnitt bzw. horizontalen Schnitt. Bei diesem Ausführungsbeispiel weist der Zwischenbereich 20 in lateraler Richtung im wesentlichen die Form eines Kreises auf. Der p-Bereich 16 ist in der Form eines geschlossenen Kreisrings um den Zwischenbereich 20 angeordnet und erstreckt sich, wie in den vorangehenden Ausführungsbeispielen, in vertikaler Richtung von der zweiten isolierenden Oxidschicht 24 bis zu der ersten isolierenden Oxidschicht 22. An der von dem Zwischenbereich 20 abgewandten Seite des p-Bereichs 16 ist ein erstes elektrisch leitfähiges Bauglied 26 angeordnet, das sich in lateraler Richtung entlang des gesamten äußeren Umfangs des p-Bereichs 16 und in vertikaler Richtung von der zweiten isolierenden Oxidschicht 24 bis zu der ersten isolierenden Oxidschicht 22 erstreckt und mit dem p-Bereich in Kontakt steht. An dem zu der zweiten isolierenden Oxidschicht 24 benachbarten Ende des ersten elektrisch leitfähigen Bauglieds 26 ist eine erste Anschlussfläche 30 gebildet. In lateraler Richtung im wesentlichen in der Mitte des Zwischenbereichs 20 ist ein in seiner lateralen Ausdehnung im wesentlichen kreisförmiger n-Bereich 18 angeordnet, der sich in vertikaler Richtung von der zweiten isolierenden Oxidschicht 24 bis zu der ersten isolierenden Oxidschicht 22 erstreckt. In der Mitte des n-Bereichs 18 ist ein zweites elektrisch leitfähiges Bauglied 28 angeordnet, das sich in vertikaler Richtung ebenfalls von der zweiten isolierenden Oxidschicht 24 bis zu der ersten isolierenden Oxidschicht 22 erstreckt und an seinem ganzen Umfang und in seiner ganzen Höhe mit dem n-Bereich 18 in Kontakt steht. An dem zu der zweiten isolierenden Oxidschicht 24 benachbarten Ende des zweiten elektrisch leitfähigen Bauglieds 28 ist eine zweite Anschlussfläche 32 ausgebildet. Das erste elektrisch leitfähige Bauglied 26 ist entlang seines gesamten Umfangs von einem kreisförmigen Graben 34 umgeben, der sich in vertikaler Richtung von der zweiten isolierenden Oxidschicht 24 bis zu der ersten isolierenden Oxidschicht 22 erstreckt und mit einem isolierenden Material gefüllt ist. Die PIN-Diode 10 gemäß dem vorliegenden Ausführungsbeispiel ist somit ebenso wie die PIN-Dioden gemäß den vorangehenden Ausführungsbeispielen abgesehen von den Anschlussflächen 30, 32 durch die isolierenden Oxidschichten 22, 24 und dem mit einem isolierenden Material gefüllten Graben 34 durch isolierende Schichten vollständig gekapselt.

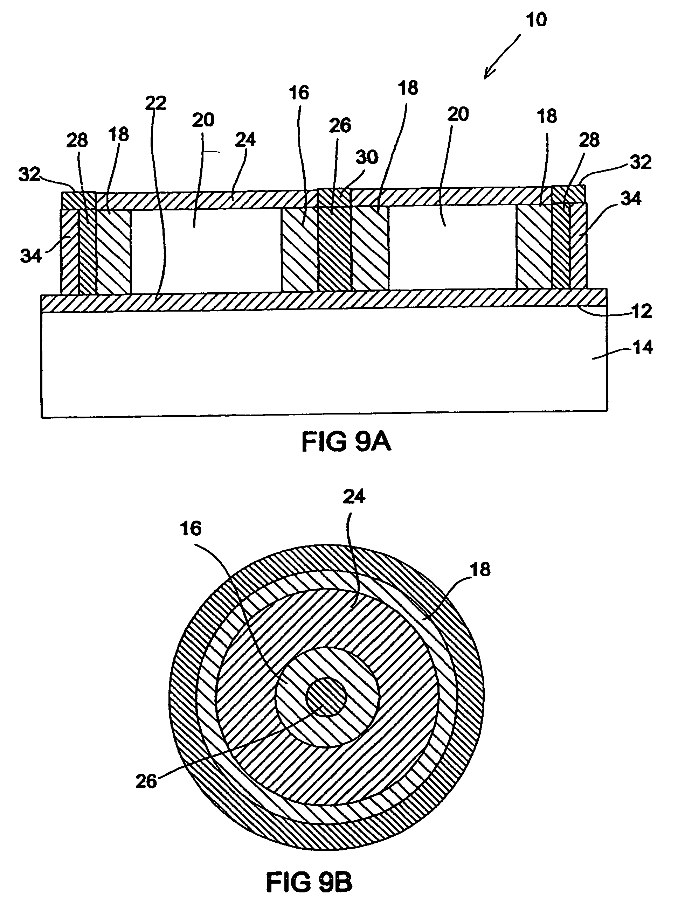

Die Fig. 9a und 9b zeigen schematisch ein weiteres Ausführungsbeispiel der PIN-Diode 10 gemäß der vorliegenden Erfindung. Dieses Ausführungsbeispiel unterscheidet sich von dem vorangehenden, in den Fig. 8a und 8b dargestellten Ausführungsbeispiel dadurch, dass der p-Bereich 16 und der n-Bereich 18 vertauscht sind. Der n-Bereich 18 ist in lateraler Richtung am äußeren Rand des im wesentlichen kreisförmigen Zwischenbereichs 20 angeordnet und grenzt entlang des gesamten Umfangs des Zwischenbereichs 20 und über seine gesamte vertikale Ausdehnung von der zweiten isolierenden Oxidschicht 24 bis zu der ersten isolierenden Oxidschicht 22 an diesen unmittelbar an. An der von dem Zwischenbereich 20 abgewandten Seite des n-Bereichs 18 ist das zweite elektrisch leitfähige Bauglied 28 angeordnet, das sich in lateraler Richtung kreisförmig entlang des gesamten äußeren Umfangs des n-Bereichs 18 und in vertikaler Richtung von der zweiten isolierenden Oxidschicht 24 bis zu der ersten isolierenden Oxidschicht 22 erstreckt und mit dem n-Bereich 18 in Kontakt steht. An dem zu der zweiten isolierenden Oxidschicht 24 benachbarten Ende des zweiten elektrisch leitfähigen Bauglieds 28 ist die zweite Anschlussfläche 32 ausgebildet. In lateraler Richtung im wesentlichen in der Mitte des Zwischenbereichs 20 ist der p-Bereich 16 angeordnet, der sich in vertikaler Richtung von der zweiten isolierenden Oxidschicht 24 bis zu der ersten isolierenden Oxidschicht 22 erstreckt. Im wesentlichen in der Mitte des ringförmigen p-Bereichs 16 ist das erste elektrisch leitfähige Bauglied 26 angeordnet, das sich von der zweiten isolierenden Oxidschicht 24 bis zu der ersten isolierenden Oxidschicht 22 erstreckt und über seine gesamte Höhe und seinen gesamten Umfang mit dem p-Bereich 16 in Kontakt steht. An dem zu der zweiten isolierenden Oxidschicht 24 benachbarten Ende des ersten elektrisch leitfähigen Bauglieds 26 ist die erste Anschlussfläche 30 ausgebildet. In allen weiteren Merkmalen entspricht das vorliegende Ausführungsbeispiel dem in den Fig. 8a und 8b dargestellten Ausführungsbeispiel.

Die in den Fig. 2a bis 9b dargestellten Ausführungsbeispiele unterscheiden sich von dem ersten Ausführungsbeispiel der PIN-Diode 10 gemäß der vorliegenden Erfindung nur in der lateralen Gestalt und Anordnung der einzelnen Bauglieder. Die vertikale Struktur ist bei allen Ausführungsbeispielen gleich. Auf der Oberfläche 12 des Substrats 14 sind zwischen der ersten isolierenden Oxidschicht 22 und der zweiten isolierenden Oxidschicht 24 der p-Bereich 16, der n-Bereich 18, der Zwischenbereich 20, das erste elektrisch leitfähige Bauglied 26 und das zweite elektrisch leitfähige Bauglied 28 angeordnet. Der p-Bereich 16, der n-Bereich 18, der Zwischenbereich 20, das erste elektrisch leitfähige Bauglied 26 und das zweite elektrisch leitfähige Bauglied 28 erstrecken sich in vertikaler Richtung, d. h. in der Richtung senkrecht zu der Oberfläche 12 des Substrats 14 von der zweiten isolierenden Oxidschicht 24 bis zu der ersten isolierenden Oxidschicht 22. Der p-Bereich 16 und der Zwischenbereich 20 bzw. der Zwischenbereich 20 und der n-Bereich 18 grenzen jeweils großflächig und insbesondere in vertikaler Richtung von der zweiten isolierenden Oxidschicht 24 bis zu der ersten isolierenden Oxidschicht 22 unmittelbar aneinander an. Ferner grenzen der p-Bereich 16 und das erste elektrisch leitfähige Bauglied 26 bzw. der n-Bereich 18 und das zweite elektrisch leitfähige Bauglied 28 jeweils großflächig, d. h. insbesondere in vertikaler Richtung von der zweiten isolierenden Oxidschicht 24 bis zu der ersten isolierenden Oxidschicht 22 unmittelbar aneinander an und bilden einen großflächigen Kontakt bzw. einen großflächigen elektrischen Übergang zwischen dem p-Bereich 16 und dem ersten elektrisch leitfähigen Bauglied 26 bzw. dem n-Bereich 18 und dem zweiten elektrisch leitfähigen Bauglied 28. An dem zu der zweiten isolierenden Oxidschicht 24 benachbarten Ende bzw. der zu der zweiten isolierenden Oxidschicht 24 benachbarten Oberkante des ersten elektrisch leitfähigen Bauglieds 26 und des zweiten elektrisch leitfähigen Bauglieds 28 sind jeweils eine erste Anschlussfläche 30 bzw. eine zweite Anschlussfläche 32 ausgebildet. In lateraler Richtung sind der p-Bereich 16, der n-Bereich 18, der Zwischenbereich 20, das erste elektrisch leitfähige Bauglied 26 und das zweite elektrisch leitfähige Bauglied 28 in jedem Ausführungsbeispiel gemeinsam von einem Graben 34 vollständig umgeben, der sich in vertikaler Richtung von der zweiten isolierenden Oxidschicht 24 bis zu der ersten isolierenden Oxidschicht 22 erstreckt und mit isolierendem Material, beispielsweise mit einem Oxid, gefüllt ist. Der p-Bereich 16, der n-Bereich 18, der Zwischenbereich 20, das erste elektrisch leitfähige Bauglied 26 und das zweite elektrisch leitfähige Bauglied 28 sind somit, abgesehen von den Anschlussflächen 30, 32, jeweils durch die erste isolierende Oxidschicht 22, die zweite isolierende Oxidschicht 24 und den mit dem isolierenden Material gefüllten Graben 34 vollständig gekapselt und gegenüber der Umwelt elektrisch isoliert.

Die oben beschriebenen und in den Fig. 1a bis 9b dargestellten Ausführungsbeispiele der PIN-Diode 10 gemäß der vorliegenden Erfindung unterscheiden sich im wesentlichen durch die laterale Anordnung der einzelnen Bauglieder. Bei allen Ausführungsbeispielen können der p-Bereich 16 (116), der n-Bereich 18 (218) und der Zwischenbereich 20 aus Si, GaAs oder einem anderen geeigneten Halbleitermaterial bestehen, das im p-Bereich 16 (116) bzw. im n-Bereich 18 (218) durch geeignete p-Dotierung bzw. n-Dotierung p-leitfähig bzw. n-leitfähig ist.

Bei allen oben dargestellten Ausführungsbeispielen erstrecken sich der p-Bereich 16, der n-Bereich 18 und die elektrisch leitfähigen Bauglieder 26, 28 in vertikaler Richtung von der zweiten isolierenden Oxidschicht 24 bis zu der ersten isolierenden Oxidschicht 22.

Alle oben dargestellten Ausführungsbeispiele weisen elektrisch leitfähige Bauglieder 26, 28 auf, welche sich in vertikaler Richtung von der zweiten isolierenden Oxidschicht 24 bis zu der ersten isolierenden Oxidschicht 22 erstrecken und auch aufgrund ihrer lateralen Ausdehnung einen großflächigen elektrischen Kontakt zu dem p-Bereich 16 bzw. dem n-Bereich 18 bilden. Die elektrisch leitfähigen Bauglieder 26, 28 dienen in dieser Anordnung dazu, auch bei Stromfluss durch die PIN-Diode 10, der in den nicht ideal leitenden p-Bereich 16 und n-Bereich 18 einen Spannungsabfall zur Folge hat, einen Spannungsabfall in vertikaler Richtung bzw. in horizontaler Richtung quer zur Hauptstromrichtung in der PIN-Diode 10 zu vermeiden und somit eine über den Querschnitt des Zwischenbereichs 20 homogene Stromverteilung zu gewährleisten. Die elektrisch leitfähigen Bauglieder 26, 28 können Wolfram, Metall-Silizid oder ein anderes geeignetes, ausreichend leitfähiges Material aufweisen.

Alle oben dargestellten Ausführungsbeispiele der PIN-Diode 10 weisen einen Graben 34 auf, der die einzelnen Bauglieder der PIN-Diode 10 in lateraler Richtung vollständig umgibt, sich in vertikaler Richtung von der zweiten isolierenden Oxidschicht bis zu der ersten isolierenden Oxidschicht 22 erstreckt und mit einem isolierenden Material gefüllt ist. Der Graben 34 dient im wesentlichen dazu, die PIN-Diode 10 gegenüber lateral benachbarten Bauelementen oder Halbleiterstrukturen auf der ersten Oberfläche 12 des Substrats 14 zu isolieren. Abhängig von der Anwendung der PIN-Diode 10, abhängig davon, ob auf dem Substrat 14 weitere Bauelemente oder Halbleiterstrukturen angeordnet sind und von welcher Art diese sind, kann der Graben 34 auch weggelassen oder anders ausgeführt werden. Zum Beispiel ist es möglich, den Graben 34 nicht mit einem isolierenden Material zu füllen, sondern nur seine zu den Baugliedern der PIN-Diode 10 gerichtete Oberfläche mit einer isolierenden Oxidschicht zu versehen. Ferner kann der Graben 34 beispielsweise in lateraler Richtung nur an den Orten ausgeführt sein, an denen andere Bauelemente oder Halbleiterstrukturen zu der PIN-Diode 10 benachbart sind, und an den Orten weggelassen werden, an denen die PIN-Diode 10 an einen Rand des Substrats 14 angrenzt.

In allen oben dargestellten Ausführungsbeispielen weisen die elektrisch leitfähigen Bauglieder 26, 28 an ihren zu der zweiten isolierenden Oxidschicht 24 benachbarten Enden bzw. Kanten Anschlussflächen 30, 32 (130, 232) auf, über die die PIN-Diode 10 bzw. der p-Bereich 16 (116) und der n-Bereich 18 (218) elektrisch kontaktiert bzw. mit anderen Bauelementen verbunden werden können. Die Anschlussflächen 30, 32 können, wie es in den Fig. 1b, 4b, 5b, 6b, 7b, 8b und 9b angedeutet ist, in ihrer lateralen Ausdehnung im wesentlichen der lateralen Ausdehnung der elektrisch leitfähigen Bauglieder 26, 28 folgen oder auch eine davon abweichende, für die jeweilige Anwendung der PIN-Diode 10 geeignete laterale Ausdehnung aufweisen. Ferner kann beispielsweise auf eine Anschlussfläche verzichtet werden, wenn ein p-Bereich 16 (116) oder ein n-Bereich 18 (218) über das jeweilige elektrisch leitfähige Bauglied 26, 28 (126, 228) oder direkt mit einem weiteren Bauelement bzw. einer weiteren Halbleiterstruktur auf der Oberfläche 12 des Substrats 14 verbunden ist. Die Anschlussflächen 30, 32 (130, 232) können ein beliebiges geeignetes Material aufweisen.

Bei allen oben dargestellten Ausführungsbeispielen ist die PIN-Diode 10 in vertikaler Richtung durch die erste isolierende Oxidschicht 22 und die zweite isolierende Oxidschicht 24 eingeschlossen. Diese qualitativ hochwertig ausführbaren passivierenden Oxidgrenzflächen weisen verschiedene Vorteile, insbesondere eine geringe Rekombinationsrate, auf. Abhängig von der Anwendung der PIN-Diode 10, den daraus folgenden Anforderungen an die PIN-Diode 10 und von ihrer Geometrie können die isolierenden Oxidschichten 22, 24 jedoch auch teilweise oder, nur in dem fall von Oxidschicht 24, ganz weggelassen oder durch andere isolierende Schichten ersetzt werden.

Ein erfindungsgemäßes Verfahren zur Herstellung einer lateralen PIN-Diode geht vorzugsweise von dem Substrat 14 und einem Bauelementsubstrat aus, die durch Waferbonden entlang der ersten Oberfläche 12 des Substrats 14 miteinander verbunden werden. Dabei entsteht die erste isolierende Oxidschicht 22. Anschließend wird das Bauelementsubstrat an seiner von der ersten Oberfläche 12 des Substrats 14 abgewandten Oberfläche erforderlichenfalls gedünnt, so dass es die Dicke bzw. die vertikale Abmessung des späteren Zwischenbereichs 20 aufweist. In dem Bauelementsubstrat wird ein p-Bereich 16 gebildet, in dem ein Graben mit der erwünschten lateralen und vertikalen Ausdehnung des späteren p-Bereichs 16 in dem Bauelementsubstrat gebildet und mit p-dotiertem Polysilizium gefüllt wird. Ferner wird ein n-Bereich 18 in dem Bauelementsubstrat gebildet, in dem ein Graben mit der erwünschten lateralen und vertikalen Ausdehnung des späteren n-Bereichs 18 in dem Bauelementsubstrat gebildet und mit n-dotiertem Polysilizium gefüllt wird. Der p-Bereich 16 und der n-Bereich 18 werden beabstandet voneinander gebildet. Zwischen dem p-Bereich 16 und dem n-Bereich 18 wird ein Zwischenbereich 20 in dem Bauelementsubstrat gebildet, wobei eine Dotierungskonzentration des Zwischenbereichs 20 niedriger ist als eine Dotierungskonzentration des p-Bereichs 16 und niedriger ist als eine Dotierungskonzentration des n-Bereichs 18. Vorzugsweise weist das Bauelementsubstrat ein Halbleitermaterial auf, welches das Halbleitermaterial des Zwischenbereichs 20 bildet. In einem an den Zwischenbereich 20 angrenzenden Abschnitt des Bauelementsubstrats wird ein Graben 34 gebildet, der sich ausgehend von einer von der ersten Oberfläche 12 des Substrats 14 abgewandten Oberfläche des Bauelementsubstrats ausgehend bis zu der ersten isolierenden Oxidschicht erstreckt, und der vorzugsweise direkt an den Zwischenbereich 20 angrenzt. Der Graben 34 wird mit einem isolierenden Material gefüllt. Der Graben 34 wird ferner in an den p-Bereich 16 und an den n-Bereich 18 angrenzenden Abschnitten des Bauelementsubstrats gebildet, so dass er den p-Bereich 16, den n-Bereich 18 und den Zwischenbereich 20 lateral vollständig umschließt und von lateral benachbarten Bauelementen oder Halbleiterstrukturen in dem Bauelementsubstrat trennt und isoliert. Ferner werden ein erstes elektrisch leitfähiges Bauglied 26 und ein zweites elektrisch leitfähiges Bauglied 28 gebildet, welche an eine von dem Zwischenbereich 20 abgewandten Seite des p-Bereichs 16 bzw. des n-Bereichs 18 angrenzt. Die elektrisch leitfähigen Bauglieder 26, 28 erstrecken sich jeweils in vertikaler Richtung von der von der ersten Oberfläche 12 des Substrats 14 abgewandten Oberfläche des Bauelementsubstrats bis zu der ersten isolierenden Oxidschicht 22 und in lateraler Richtung entlang der gesamten von dem Zwischenbereich 20 abgewandten Seite des p-Bereichs 16 bzw. des n-Bereichs 18. Die elektrisch leitfähigen Bauglieder 26, 28 bilden so großflächige elektrische Kontakte mit dem p-Bereich 16 bzw. dem n-Bereich 18. Die elektrisch leitfähigen Bauglieder 26, 28 werden gebildet, in den beschriebenen Bereichen in dem Bauelementsubstratgräben mit der erwünschten Ausdehnung des jeweiligen späteren elektrisch leitfähigen Bauglieds 26, 28 und mit einem ausreichend leitfähigen Material, beispielsweise Wolfram oder Metall-Silizid, gefüllt werden. An den von der ersten Oberfläche 12 des Substrats 14 abgewandten Oberfläche der elektrisch leitfähigen Bauglieder 26, 28 wird eine erste Anschlussfläche 30 bzw. eine zweite Anschlussfläche 32 gebildet, welche später zur elektrischen Verbindung der PIN-Diode 10 bzw. des p-Bereichs 16 und des n-Bereichs 18 mit anderen elektrischen Einrichtungen oder Bauelementen dienen. Ferner wird über den von der ersten Oberfläche 12 des Substrats 14 abgewandten Oberflächen des p-Bereichs 16, des n-Bereichs 18 und des Zwischenbereichs 20 eine zweite isolierende Oxidschicht gebildet, welche nur die erste Anschlussfläche 30 und die zweite Anschlussfläche 32 nicht bedeckt.

Der p-Bereich 16 bzw. der n-Bereich 18 kann abweichend von dem letzten Ausführungsbeispiel durch Implantieren von p-Material bzw. n-Material in den erwünschten vorbestimmten Bereich des späteren p-Bereichs 16 bzw. des n-Bereichs 18 in dem Bauelementsubstrat gebildet werden. Der p-Bereich 16 bzw. der n-Bereich 18 kann jedoch auch durch Bilden eines Grabens in dem Bauelementsubstrat in einem vorbestimmten Bereich, der an den erwünschten Bereich des späteren p-Bereichs 16 bzw. n-Bereichs 18 angrenzt, Einbringen von p-Material bzw. n-Material in den Graben und Eindiffundieren des eingebrachten Materials in die den Graben umgebenden Bereiche des Bauelementsubstrats gebildet werden.

Ferner abweichend von dem beschriebenen Ausführungsbeispiel des erfindungsgemäßen Verfahrens zur Herstellung einer PIN-Diode kann die erste isolierende Oxidschicht 22 oder an ihrer Stelle eine andere geeignete isolierende Schicht statt durch Waferbonden durch ein anderes geeignetes Verfahren hergestellt werden. Beispielsweise kann auf ein Substrat zunächst eine isolierende Schicht und dann eine Schicht aus einem niedrig dotierten Halbleitermaterial, das sich als Material für den Zwischenbereich einer PIN-Diode eignet, aufgewachsen werden. In dieser niedrig dotierten Halbleiterschicht werden dann, beispielsweise durch die oben beschriebenen Verfahrensschritte, ein p-Bereich und ein n-Bereich gebildet, die voneinander beabstandet sind. Dadurch wird automatisch der Zwischenbereich gebildet. In weiteren Verfahrensschritten können dann, wie oben beschrieben, ein Graben gebildet werden, welcher den p-Bereich, den n-Bereich und den Zwischenbereich in lateraler Richtung vollständig umgibt, Anschlussflächen für den p-Bereich und den n-Bereich, elektrisch leitfähige Bauglieder für den p-Bereich und den n-Bereich und eine weitere isolierende Schicht an der von dem Substrat abgewandten Oberfläche des Zwischenbereichs, des p-Bereichs und des n-Bereichs gebildet werden.

Nachdem durch eines der beschriebenen Verfahren die PIN-Diode 10 gemäß der vorliegenden Erfindung gebildet ist, kann, wenn es erwünscht ist, das Substrat 14 beispielsweise durch Ätzen entfernt werden.

Durch die beschriebenen Verfahren sind alle oben anhand der Fig. 1a bis 9a dargestellten erfindungsgemäßen PIN-Dioden 10 herstellbar.

Ferner kann ein Rückseitenkontakt zu dem p-Bereich 16 bzw. dem n-Bereich 18 hergestellt werden, indem vor oder bei der Herstellung des p-Bereichs 16 bzw. des n-Bereichs 18 ein an den p-Bereich 16 bzw. n-Bereich 18 angrenzender Bereich der ersten isolierenden Oxidschicht 22 entfernt wird.

### Bezugszeichenliste

- 10: PIN-Diode
- 12: erste Oberfläche des Substrats
- 14: Substrat
- 16: p-Bereich
- 18: n-Bereich
- 20: Zwischenbereich
- 22: erste isolierende Oxidschicht
- 24: zweite isolierende Oxidschicht
- 26: erstes elektrisch leitfähiges Bauglied
- 28: zweites elektrisch leitfähiges Bauglied
- 30: erste Anschlussfläche
- 32: zweite Anschlussfläche
- 34: Graben
- 116: weiterer p-Bereich
- 126: drittes elektrisch leitfähiges Bauglied
- 130: dritte Anschlussfläche
- 218: weiterer n-Bereich
- 228: drittes elektrisch leitfähiges Bauglied
- 232: dritte Anschlussfläche

## Patentansprüche

1. Verfahren zur Herstellung einer PIN-Diode (10) mit einer isolierenden Schicht (22) auf einem Wafer (14) und mit einem Bauelementbereich auf der isolierenden Schicht (22), mit folgenden Schritten:
Bilden eines p-Bereichs (16) in dem Bauelementbereich;
Bilden eines n-Bereichs (18) in dem Bauelementbereich beabstandet von dem p-Bereich (18);
Bilden eines Zwischenbereichs (20) in dem Bauelementbereich zwischen dem p-Bereich (16) und dem n-Bereich (18), wobei eine Dotierungskonzentration des Zwischenbereichs (20) niedriger ist als eine Dotierungskonzentration des p-Bereichs (16) und niedriger ist als eine Dotierungskonzentration des n-Bereichs (18);
Bilden eines ersten elektrisch leitfähigen Baugliedes (26) an einer von dem Zwischenbereich (20) abgewandten Seite des p-Bereichs (16); und
Bilden eines zweiten elektrisch leitfähigen Baugliedes (28) an einer von dem Zwischenbereich (20) abgewandten Seite des n-Bereichs (18),
wobei sich der p-Bereich (16), der n-Bereich (18), das erste elektrisch leitfähige Bauglied (26) und das zweite elektrisch leitfähige Bauglied (28) bis zu der isolierenden Schicht (22) erstrecken.

2. Verfahren gemäß Anspruch 1 mit folgenden Schritten:
Bereitstellen des Wafers (14) und eines Bauelementwafers; und
Waferbonden von Wafer (14) und Bauelementwafer,
wobei der p-Bereich (16), der n-Bereich (18) und der Zwischenbereich (20) in dem Bauelementwafer gebildet werden und von dem Wafer (14) isoliert sind.

3. Verfahren gemäß Anspruch 2 mit folgenden Schritten:
Bilden eines Grabens (34) in einem an den Zwischenbereich (20) angrenzenden Abschnitt des Bauelementwafers, wobei sich der Graben (34) ausgehend von einer Oberfläche des Bauelementwafers, die dem Wafer (14) abgewandt ist, bis zu einer Oberfläche des Bauelementwafers, die dem Wafer (14) gegenüber liegt, erstreckt; und
Füllen des Grabens (34) mit einem isolierenden Material.

4. Verfahren gemäß Anspruch 3, bei dem der Graben (34) ferner in an den p-Bereich (16) und an den n-Bereich (18) angrenzenden Abschnitten des Bauelementwafers gebildet wird.

5. Verfahren gemäß einem der Ansprüche 2 bis 4, bei dem der p-Bereich (16) bzw. der n-Bereich (18) durch
Bilden eines Grabens in dem Bauelementwafer und Füllen desselben mit p-dotiertem bzw. n-dotiertem Polysilizium, oder durch
Implantieren von p-Material bzw. n-Material in vorbestimmte Bereiche des Bauelementwafers, oder durch
Bilden eines Grabens in dem Bauelementwafer, Einbringen von p-Material bzw. n-Material in denselben und Eindiffundieren des eingebrachten Materials in die den Graben umgebenden Bereiche des Bauelementwafers gebildet wird.

6. Verfahren gemäß einem der Ansprüche 1 bis 5, ferner mit folgendem Schritt:
Bilden einer isolierenden Schicht (24) über dem von der ersten Oberfläche des Wafers abgewandten Oberfläche des p-Bereichs (16), des n-Bereichs (18) und des Zwischenbereichs (20).

7. Verfahren gemäß einem der Ansprüche 1 bis 5, ferner mit folgendem Schritt:
Bilden von Anschlussflächen (30, 32) auf den von der ersten Oberfläche des Wafers (14) abgewandten Oberflächen des p-Bereichs (16) und des n-Bereichs (18).

8. PIN-Diode (10) mit einer isolierenden Schicht (22) auf einem Wafer (14) und mit einem Bauelementbereich auf der isolierenden Schicht (22), mit folgenden Merkmalen:
einem p-Bereich (16) in dem Bauelementbereich;
einem n-Bereich (18) in dem Bauelementbereich;
einem Zwischenbereich (20) in dem Bauelementbereich zwischen dem p-Bereich (16) und dem n-Bereich (18), wobei eine Dotierungskonzentration des Zwischenbereichs (20) niedriger ist als eine Dotierungskonzentration des p-Bereichs (16) und niedriger ist als eine Dotierungskonzentration des n-Bereichs (18);
einem ersten elektrisch leitfähigen Bauglied (26), das an einer von dem Zwischenbereich (20) abgewandten Seite des p-Bereichs (16) angeordnet ist; und
einem zweiten elektrisch leitfähigen Bauglied (28), das an einer von dem Zwischenbereich (20) abgewandten Seite des n-Bereichs (18) angeordnet ist ,
wobei sich der p-Bereich (16), der n-Bereich (18), das erste elektrisch leitfähige Bauglied (26) und das zweite elektrisch leitfähige Bauglied (28) bis zu der isolierenden Schicht (22) erstrecken.

9. PIN-Diode (10) gemäß Anspruch 8 mit einem Bauelementwafer auf der isolierenden Schicht (22), wobei der p-Bereich (16), der n-Bereich (18) und der Zwischenbereich (20) in dem Bauelementwafer angeordnet sind.

10. PIN-Diode (10) gemäß Anspruch 8 oder 9 mit folgendem Merkmal:
einem Graben (34) in einem an den Zwischenbereich (20) angrenzenden Abschnitt des Bauelementwafers, wobei sich der Graben (34) ausgehend von einer Oberfläche des Bauelementwafers, die dem Wafer (14) abgewandt ist, bis zu einer Oberfläche des Bauelementwafers, die dem Wafer (14) gegenüber liegt, erstreckt, und wobei der Graben (34) mit einem isolierenden Material gefüllt ist.

11. PIN-Diode (10) gemäß Anspruch 10, bei der der Graben (34) in an den p-Bereich (16) und an den n-Bereich (18) angrenzenden Abschnitten des Bauelementwafers angeordnet ist.

12. PIN-Diode (10) gemäß Anspruch 11, bei der eine durch den Graben (34) festgelegte Form des Zwischenbereichs (20) im wesentlichen rechteckförmig ist, wobei der p-Bereich (16) und der n-Bereich (18) an zwei gegenüberliegenden Seiten des Zwischenbereichs (20) angeordnet sind.

13. PIN-Diode (10) gemäß Anspruch 12, bei der sich mindestens entweder der p-Bereich (16) oder der n-Bereich (18) über eine ganze Breite des Zwischenbereichs (20) erstreckt.

14. PIN-Diode (10) gemäß Anspruch 11, bei der eine durch den Graben (34) festgelegte Form des Zwischenbereichs (20) im wesentlichen trapezförmig ist, wobei der p-Bereich (16) sich entlang einer der parallelen Seiten des Zwischenbereichs (20) erstreckt, und wobei der n-Bereich (18) sich entlang der andere der parallelen Seiten des Zwischenbereichs (20) erstreckt.

15. PIN-Diode (10) gemäß Anspruch 11, bei der eine durch den Graben (34) festgelegte Form des Zwischenbereichs (20) im wesentlichen kreisförmig ist, wobei entweder der p-Bereich (16) oder der n-Bereich (18) entlang des Rands des Zwischenbereichs (20) kreisförmig angeordnet ist, wobei der n-Bereich (18) bzw. der p-Bereich (16) im wesentlichen in der Mitte des Zwischenbereichs (20) angeordnet ist und in seiner Mitte das zweite elektrisch leitfähige Bauglied (28) bzw. das erste elektrisch leitfähige Bauglied (26) angeordnet ist.

16. PIN-Diode (10) gemäß einem der Ansprüche 8 bis 11, ferner mit folgendem Merkmal:
einer weiteren Isolierschicht (24), die die von dem Wafer (14) abgewandten Oberflächen des p-Bereichs (16), des n-Bereichs (18) und des Zwischenbereichs (20) bedeckt.

17. PIN-Diode (10) gemäß einem der Ansprüche 8 bis 16, bei der eine erste Anschlussfläche (30) mit dem p-Bereich (16) und eine zweite Anschlussfläche (32) mit dem n-Bereich (18) leitfähig verbunden sind, wobei die beiden Anschlussflächen (30, 32) an den von der ersten Oberfläche des Wafers (14) abgewandten Oberflächen des p-Bereichs (16) und des n-Bereichs (18) angeordnet sind.

18. PIN-Diode (10) gemäß einem der Ansprüche 8 bis 17, bei der der Abstand zwischen dem p-Bereich (16) und dem n-Bereich (18) mehr als 30 µm beträgt.

## Claims

1. Method for manufacturing a PIN diode (10) having an insulating layer (22) on a wafer (14) and a device area on the insulating layer (22), the method comprising the following steps:
forming a p-area (16) in the device area;
forming an n-area (18) in the device area spaced apart from the p-area (18);
forming an intermediate area (20) in the device area between the p-area (16) and the n-area (18), wherein a doping concentration of the intermediate area (20) is lower than a doping concentration of the p-area (16) and lower than a doping concentration of the n-area (18);
forming a first electrically conductive member (26) on a side of the p-area (16) which faces away from the intermediate area (20); and
forming a second electrically conductive member (28) on a side of the n-area (18) which faces away from the intermediate area (20),
wherein the p-area (16), the n-area (18), the first electrically conductive member (26) and the second electrically conductive member (28) extend to the insulating layer (22).

2. Method in accordance with claim 1, comprising the following steps:
providing the wafer (14) and a device wafer; and
wafer-bonding of wafer (14) and device wafer,
wherein the p-area (16), the n-area (18) and the intermediate area (20) are formed in the device wafer and insulated against the wafer (14).

3. Method in accordance with claim 2, comprising the following steps:
forming a trench (34) in a section of the device wafer which abuts on the intermediate area (20), wherein the trench (34) extends from a surface of the device wafer which faces away from the wafer (14) to a surface of the device wafer which is opposite to the wafer (14); and
filling the trench (34) with an insulating material.

4. Method in accordance with claim 3, wherein the trench (34) is further formed in sections of the device wafer which abut on the p-area (16) and on the n-area (18).

5. Method in accordance with one of claims 2 to 4, wherein the p-area (16) or the n-area (18), respectively, is formed by
forming a trench in the device wafer and filling the same with p-doped or n-doped polysilicon, respectively, or by implanting of p-material or n-material, respectively, in predetermined areas of the device wafer, or by
forming a trench in the device wafer, introducing of p-material or n-material, respectively, into the same and diffusing of the introduced material into the areas of the device wafer surrounding the trench.

6. Method in accordance with one of claims 1 to 5, further comprising the following step:
forming an insulating layer (24) above the surface of the p-area (16), the n-area (18), and the intermediate area (20) which faces away from the first surface of the wafer.

7. Method in accordance with one of claims 1 to 5, further comprising the following step:
forming of pads (30, 32) on the surfaces of the p-area (16) and the n-area (18) which face away from the first surface of the wafer (14).

8. PIN diode (10) having an insulating layer (22) on a wafer (14) and a device area on the insulating layer (22), comprising:
a p-area (16) in the device area;
an n-area (18) in the device area;
an intermediate area (20) in the device area between the p-area (16) and the n-area (18), wherein a doping concentration of the intermediate area (20) is lower than a doping concentration of the p-area (16) and lower than a doping concentration of the n-area (18);
a first electrically conductive member (26), which is arranged on a side of the p-area (16) which faces away from the intermediate area (20); and
a second electrically conductive member (28), which is arranged on a side of the n-area (18) which faces away from the intermediate area (20),
wherein the p-area (16), the n-area (18), the first electrically conductive member (26) and the second electrically conductive member (28) extend to the insulating layer (22).

9. PIN diode (10) in accordance with claim 8, having a device wafer on the insulating layer (22), wherein the p-area (16), the n-area (18), and the intermediate area (20) are arranged in the device wafer.

10. PIN diode (10) in accordance with claim 8 or 9, comprising:
a trench (34) in a section of the device wafer which abuts on the intermediate area (20), wherein the trench (34) extends from a surface of the device wafer which faces away from the wafer (14) to a surface of the device wafer which is opposite to the wafer (14), and wherein the trench (34) is filled with an insulating material.

11. PIN diode (10) in accordance with claim 10, wherein the trench (34) is arranged in sections of the device wafer which abut on the p-area (16) and on the n-area (18).

12. PIN diode (10) in accordance with claim 11, wherein a shape of the intermediate area (20), which is determined by the trench (34), is essentially rectangular, wherein the p-area (16) and the n-area (18) are arranged on two opposite sides of the intermediate area (20).

13. PIN diode (10) in accordance with claim 12, wherein at least either the p-area (16) or the n-area (18) extends along a whole width of the intermediate area (20).

14. PIN diode (10) in accordance with claim 11, wherein a shape of the intermediate area (20), which is determined by the trench (34), is essentially trapezoidal, wherein the p-area (16) extends along one of the parallel sides of the intermediate area (20), and wherein the n-area (18) extends along the other of the parallel sides of the intermediate area (20).

15. PIN diode (10) in accordance with claim 11, wherein a shape of the intermediate area (20), which is determined by the trench (34), is essentially circular, wherein either the p-area (16) or the n-area (18) is arranged in the shape of a circle along the edge of the intermediate area (20), wherein the n-area (18) or the p-area (16), respectively, is essentially arranged in the centre of the intermediate area (20) and wherein the second electrically conductive member (28) or the first electrically conductive member (26), respectively, is arranged in its centre.

16. PIN diode (10) in accordance with one of claims 8 to 11, further comprising:
a further insulating layer (24), which covers the surfaces of the p-area (16), the n-area (18), and the intermediate area (20) which face away from the wafer (14).

17. PIN diode (10) in accordance with one of claims 8 to 16, wherein a first pad (30) is conductively connected to the p-area (16) and a second pad (32) is conductively connected to the n-area (18), wherein the two pads (30, 32) are arranged at the surfaces of the p-area (16) and the n-area (18) which face away from the first surface of the wafer (14).

18. PIN diode (10) in accordance with one of claims 8 to 17, wherein the distance between the p-area (16) and the n-area (18) is more than 30 µm.

## Revendications

1. Procédé de production d'une diode (10) PIN ayant une couche (22) isolante sur une tranche (14) et ayant une zone de composants sur la couche (22) isolante, comprenant les stades suivants :
formation d'une zone (16) du type p dans la zone du composant ;
formation d'une zone (18) du type n dans la zone du composant à distance de la zone (18) du type p ;
formation d'une zone (20) intermédiaire dans la zone du composant comprise entre la zone (16) du type p et la zone (18) du type n, une concentration de dopage de la zone (20) intermédiaire étant plus basse qu'une concentration de dopage de la zone (16) du type p et plus basse qu'une concentration de dopage de la zone (18) du type n ;
formation d'un premier élément (26) conducteur de l'électricité sur un côté, éloigné de la zone (20) intermédiaire, de la zone (16) du type p ; et
formation d'un deuxième élément (28) conducteur de l'électricité sur un côté, éloigné de la zone (20) intermédiaire, de la zone (18) du type n,
la zone (16) du type p, la zone (18) du type n, le premier élément (26) conducteur de l'électricité et le deuxième élément (28) conducteur de l'électricité s'étendant jusqu'à la couche (22) isolante.

2. Procédé suivant la revendication 1 comprenant les stades suivants :
mise à disposition de la tranche (14) et d'une tranche de composant ; et
liaison de la tranche (14) et de la tranche de composant ;
la zone (16) du type p, la zone (18) du type n et la zone (20) intermédiaire étant formées dans la tranche de composant et étant isolées de la tranche (14).

3. Procédé suivant la revendication 2 comprenant les stades suivants :
formation d'un sillon (34) dans une partie de la tranche de composant adjacente à la zone (20) intermédiaire, le sillon (34) s'étendant en partant d'une surface de la tranche de composant qui est éloignée de la tranche (14) jusqu'à une surface de la tranche de composant qui est en face de la tranche (14) ; et
remplissage du sillon (34) par une matière isolante.

4. Procédé suivant la revendication 3, dans lequel le sillon (34) est formé, en outre, dans des parties de la tranche de composant adjacente à la zone (16) du type p et à la zone (18) du type n.

5. Procédé suivant l'une des revendications 2 à 4, dans lequel la zone (16) du type p ou la zone (18) du type n est formée par
formation d'un sillon dans la tranche de composant et remplissage de celui-ci par du polysilicium à dopage p ou à dopage n ou par
implantation de matière du type p ou de matière du type n dans des zones déterminées à l'avance de la tranche du composant, ou par
formation d'un sillon dans la tranche du composant, introduction de matière du type p ou de matière du type n dans celui-ci et diffusion de la matière introduite dans les zones de la tranche du composant qui entoure le sillon.

6. Procédé suivant l'une des revendications 1 à 5, comprenant, en outre, le stade suivant :
formation d'une couche (24) isolante sur la surface, éloignée de la première surface de la tranche, de la zone (16) du type p, de la zone (18) du type n et de la zone (20) intermédiaire.

7. Procédé suivant l'une des revendications 1 à 5, comprenant, en outre, le stade suivant :
formation de surfaces (30, 32) de bornes sur les surfaces, éloignées de la première surface de la tranche (14), de la zone (16) du type p et de la zone (18) du type n.

8. Diode (10) PIN ayant une couche (22) isolante sur une tranche (14) et ayant une zone de composant sur la couche (22) isolante, comprenant les caractéristiques suivantes :
une zone (16) du type p dans la zone du composant ;
une zone (18) du type n dans la zone du composant ;
une zone (20) intermédiaire dans la zone du composant entre la zone (16) du type p et la zone (18) du type n, une concentration de dopage de la zone (20) intermédiaire étant plus basse qu'une concentration de dopage de la zone (16) du type p et plus basse qu'une concentration de dopage de la zone (18) du type n ;
un premier élément (26) conducteur de l'électricité qui est disposé d'un côté, éloigné de la zone (20) intermédiaire, de la zone (16) du type p ; et
un deuxième élément (28) conducteur de l'électricité qui est disposé d'un côté, éloigné de la zone (20) intermédiaire, de la zone (18) du type n,
dans lequel la zone (16) du type p, la zone (18) du type n, le premier élément (26) conducteur de l'électricité et le deuxième élément (28) conducteur de l'électricité s'étendent jusqu'à la couche (22) isolante.

9. Diode (10) PIN suivant la revendication 8 ayant une tranche de composant sur la couche (22) isolante, la zone (16) du type p, la zone (18) du type n et la zone (20) intermédiaire étant disposées dans la tranche de composant.

10. Diode (10) PIN suivant la revendication 8 ou 9 ayant la caractéristique suivante :
un sillon (34) dans une partie de la tranche de composant adjacente à la zone (20) intermédiaire, le sillon (34) s'étendant à partir d'une surface de la tranche de composant qui est éloignée de la tranche (14) jusqu'à une surface de la tranche de composant qui est en face de la tranche (14); et le sillon (34) étant rempli d'une matière isolante.

11. Diode (10) PIN suivant la revendication 10, dans laquelle le sillon (34) est disposé dans des parties de la tranche du composant qui sont adjacentes à la zone (16) du type p et à la zone (18) du type n.

12. Diode (10) PIN suivant la revendication 11, dans laquelle une forme, fixée par le sillon (34), de la zone (20) intermédiaire est sensiblement rectangulaire, la zone (16) du type p ou la zone (18) du type n étant disposées sur deux côtés opposés de la zone (20) intermédiaire.

13. Diode (10) PIN suivant la revendication 12, dans laquelle au moins la zone (16) du type p ou la zone (18) du type n s'étend sur toute la largeur de la zone (20) intermédiaire.

14. Diode (10) PIN suivant la revendication 11, dans laquelle une forme, fixée par le sillon (34), de la zone (20) intermédiaire est sensiblement trapézoïdale, la zone (16) du type p s'étendant le long de l'un des côtés parallèles de la zone (20) intermédiaire et la zone (18) du type n s'étendant le long de l'autre des côtés parallèles de la zone (20) intermédiaire.

15. Diode (10) PIN suivant la revendication 11, dans laquelle une forme, fixée par le sillon (34), de la zone (20) intermédiaire est essentiellement circulaire, soit la zone (16) du type p soit la zone (18) du type n étant disposée circulairement le long du bord de la zone (20) intermédiaire, la zone (18) du type n ou la zone (16) du type p étant disposée sensiblement au milieu de la zone (20) intermédiaire et le deuxième élément (28) conducteur de l'électricité ou le premier élément (26) conducteur de l'électricité étant disposé en son milieu.

16. Diode (10) PIN suivant l'une des revendications 8 à 11, comprenant, en outre, la caractéristique suivante :
une autre couche (24) isolante qui revêt la surface, éloignée de la tranche (14), de la zone (16) du type p, de la zone (18) du type n et de la zone (20) intermédiaire.

17. Diode (10) PIN suivant l'une des revendications 8 à 16, dans laquelle une première surface (30) de borne ayant la zone (16) du type p et une deuxième surface (32) de borne ayant la zone (18) du type n sont reliées d'une manière conductrice, les deux surfaces (30, 32) de bornes étant disposées sur les surfaces, éloignées de la première surface de la tranche (14), de la zone (16) du type p et de la zone (18) du type n.

18. Diode (10) PIN suivant l'une des revendications 8 à 17, dans laquelle la distance entre la zone (16) du type p et la zone (18) du type n est supérieure à 30 µm.
